# EUROPEAN PATENT SPECIFICATION

(11) **EP 2 806 310 B1**
(45) Date of publication and mention of the grant of the patent: **04.01.2017**
(21) Application number: 14001517.3
(22) Date of filing: 29.04.2014
(51) Int. Cl.: G03F 1/92, G03F 1/00, G03F 7/20, B41C 1/10

(54) **Making flexographic printing plates from photopolymers**
Herstellung von Flexodruckplatten von Photopolymeren
Fabrication de plaques d'impression flexographiques à partir de photopolymères

(30) Priority: 24.05.2013 US 201313902301
(43) Date of publication of application: 26.11.2014
(73) Proprietor: Chemence, Inc., Alpharetta, GA 30005 (US)
(72) Inventor: Maneira, John P., Alpharetta, Georgia 30022 (US); Chobadzhiev, Krasimir G., Alpharetta, Georgia 30004 (US)
(74) Representative: Morgan, David James

(56) References cited:
- EP-A2- 2 437 120
- WO-A1-03/020529
- GB-A- 2 384 864
- US-A1- 2004 244 643
- US-A1- 2013 255 517
- US-A1- 2014 080 042

## Description

This invention is in the field of printing, more specifically in the field of making flexographic printing plates from photopolymers, and still more specifically in controlling the exposure of the photopolymers in an ultraviolet (UV) exposure unit. The invention is also in the field of making image negatives for such exposures more specifically negatives printed on polymeric film using inkjet printers, more specifically to such negatives printed with solvent-based (that is non aqueous) links, and still more specifically in making such negatives with optimum opacity. The invention also pertains to establishing and using the proper combinations of such negatives and UV light intensity.

Flexographic printing plates may be made from photopolymers cured by exposure to actinic radiation. To create a relief image on the photopolymer layer, a film negative is placed between the source of radiation, typically ultraviolet (UV) light, and the photopolymer layer. In the remainder of this description and the claims, the word "light" refers to any actinic radiation containing a range of wavelengths capable of causing photoreactive substances such as, but not limited to, photopolymers, to cure. This light includes UV but may include actinic radiation of other wavelengths without limitation unless claimed otherwise.

The relief is created where light passes through the clear areas of the negative. To produce the relief, the photopolymer covered by the dark areas of the negative must be completely shielded from the light. If any degree of polymerization occurs in the covered areas, the photopolymer cannot be removed successfully by washing or scrubbing, and the plate is wasted. One method of making detailed negatives for exposure of photopolymers in a flexo printing plate exposure unit uses an inkjet printer to print a UV-blocking ink onto a clear plastic, e.g., polyester film. At present, only water-based inks are sufficiently opaque. To use water-based inkjet inks, the surface of the film material must be receptive to, or made to be receptive to, water-based inks; that is, the image must adhere to the plastic and dry quickly without migrating so as to preserve detail. The plastic material may be made inkjet-receptive by coating it with, e.g., a micro-porous coating or a coating of inkjet-receptive polymer, or the material may be treated in some other manner such as acid etching, etc. to produce a surface that allows the ink to adhere to the film and dry quickly without migrating. An untreated plastic film may alternatively be printed with an inkjet ink directly so long as the ink and the plastic are mutually compatible. Untreated films are about one-tenth the cost of films treated for use with aqueous inks. Solvent-based inks also have the advantage of being printable at roughly three times the speed of aqueous inks, but at present such inks cannot be used to make flexo plates because they do not create black images which are sufficiently opaque to prevent partial (therefore unacceptable) curing of the photopolymer under the imaged areas. A need exists for solvent-based inks that will either by themselves, or in combination with a filter, such as a dyed film, prevent UV radiation in the applicable wavelength range from penetrating the imaged areas to cause unwanted polymerization.

The present invention consists of embodiments of solvent-based inks containing combinations of additives that either alone or together with filters such as dyed films yield image opacities suitable for making photopolymer-based flexo plates.

United Kingdom Patent No. GB 2384864 A (Komatsu et al.) and European Patent Application No. 2437120 A1 (Chemence, Inc.) disclose laminates and methods for making laminates to be used in light-transmitting applications, in which aqueous inks are printed on aqueous ink compatible surfaces. Solvent-based inks are not mentioned because at the time those inventions were made, no solvent-based inks existed which could produce printed images with sufficient opacity to polymerizing_radiation to be used in flexographic plate-making processes.

PCT Publication WO 03/020529 A1 (Avery Dennison Corporation) discloses a process for manufacturing three-dimensionally shaped polymeric sheets and laminates with colour-matched digitally printed full colour ink jet images. A flexible thermoformable polymeric baseweb is placed in an inkjet printer and a solvent based (nonaqueous) digital printing ink is applied directly to the baseweb in the absence of an ink receptive layer on the baseweb to form a decorative pattern in multiple colours in a single pass through the printer.

U.S. Published Patent Application No. 2004/0244643 A1 (De Voeght et al.) discloses ink compositions for printing comprising a UV-absorbing compound according to a formula disclosed in the patent specification whereby the different symbols are disclosed in the claims and description. The invention further encompasses a method for making a UV-sensitive printing element using the thus defined ink compositions.

U.S. Published Patent Application No. 2013/255517 A1 (Maneira et al.) is the currently-pending U.S. parent to the instant patent application and discloses essentially the same invention. The instant application claims priority to '517 under the Paris Convention.

U.S. Published Patent Application No. 2014/080042 (Maneira) discloses a flexography substrate for making island plates with liquid photopolymers which has a tie-coat applied to one side to hold the photopolymers in place on the substrate and an adhesive layer applied to the other side. A clear release liner is applied to the adhesive layer, and an inkjet-receptive coating is applied to the clear release liner. The masking image for the islands is applied to the clear release liner using an inkjet printer. After the substrate has been used to make a flexographic plate, the release liner is peeled off of the adhesive layer. The flexographic plate can then be applied to a print roll without the step of manually applying adhesive to it.

With the exception of Application No. '517, none of these references solves the problem of making negatives or laminates for exposing photopolymers to ultraviolet light without using aqueous inks.

According to one aspect of the present invention a solvent-based inkjet negative comprises a polymeric film compatible with solvent-based ink and having inked areas, the polymeric film being thin in one dimension, broad in the two other dimensions, a surface in the two other dimensions to be illuminated by a light having an initial intensity, a first combination of light filtering substances uniformly spread in the other two dimensions; the ink comprising a second combination of light filtering substances_and being printed on the surface, the first and second combinations of light filtering substances preventing polymerization of photopolymers opposite to the surface to be illuminated when light is shone on the surface to be illuminated, the first combination of light filtering substances is taken from the list of: a. none; b. at least one layer of fluorescent substance; c. at least one layer of light-reflecting substance; d. at least one layer of light absorbing substance; e. at least one fluorescent substance dispersed within the film; f. at least one light-reflecting substance dispersed within the film; g. at least one light absorbing substance dispersed within the film; and h. any combination of b. through g. above; and said second combination of light filtering substances is taken from the list of: i. a fluorescent substance; j. a light-reflecting substance; k. a light absorbing substance; and l. any combination of i. through k. above.

Preferably said first combination of light filtering substances reduces the initial intensity by at least 50% and said second combination of light filtering substances reduces the initial intensity by at least an additional 30 percentage points.

According to another aspect of the present invention a light filtering laminate is provided having at least one layer comprising a first substance taken from the list of a. at least one substance which absorbs light of a specified wavelength range and fluoresces in a wavelength other than the specified wavelength range; b. at least one substance that reflects light of a specified wavelength range away from a layer of photoreactive material; c. at least one substance that absorbs light of a specified wavelength range and converts it to heat; and d. any combination of b. to c. above; and at least one layer printed with a negative image comprising a solvent-based ink, the ink comprising a second substance taken from the list of: e. at least one substance which absorbs light of a specified wavelength range and fluoresces in a wavelength other than the specified wavelength range; f. at least one substance that reflects light of a specified wavelength range away from the photoreactive material; g. at least one substance that absorbs light of a specified wavelength range and converts it to heat; and h. any combination of f. through g. above, the unprinted areas in the light filtering laminate reducing the intensity of light of a specified wavelength range passing through the light filtering laminate by at least 50% and the ink reducing the intensity of the light of a specified wavelength range passing through the printed areas by at least an additional 30_percentage points.

Preferably the light filtering laminate comprises at least one layer with a first substance and said at least one layer printed with a negative image are one and the same.

Suitably the light filtering laminate has a specified wavelength range of about 200 to 400 nanometers.

Conveniently the light filtering laminate has a specified wavelength range of about 240 to 360 nanometers.

According to a further aspect of the present invention a method is provided for making a light filtering laminate, comprising the steps of a. adding at least zero light filtering substances to at least one layer of light transmitting material; b. adding at least one light filtering substance to a solvent-based inkjet printing ink; c. using the ink from step b. to print a negative image on at least one layer of film compatible with solvent-based inkjet ink; and d. superimposing any resulting plurality of layers, the light filtering substances being taken from the list of: e. at least one substance which absorbs light of a specified wavelength range and fluoresces in a wavelength other than a specified wavelength range; f. at least one substance that reflects light of a specified wavelength range away from the photo reactive material and g. at least one substance that absorbs light of a specified wavelength range and converts it to heat, the unprinted areas in the light filtering laminate reducing the intensity of light of a specified wavelength range passing through the light filtering laminate by at least 50%; and the ink further reducing the intensity of light of a specified wavelength range passing through the light filtering laminate by at least an additional 30 percentage points.

Preferably said specified wavelength range is about 200 to 400 nanometers.

Suitably said specified wavelength range is about 240 to 360 nanometers.

The present invention enables untreated polymeric films (e.g., polyester) to be used for photopolymer flexo plate making by augmenting the ability of solvent-based inkjet inks to block UV radiation. This is accomplished by adding either brightening compounds or light absorbing or reflecting compounds (or combinations of these) to the ink, and, if necessary, increasing light absorption by either adding dye to the negative film itself, coating the film with a layer of light filtering material, or applying one or more light filtering sheets to one or both sides of the film.

The light absorbing compounds behave like dyes or pigments, while the brighteners work by absorbing UV light, modifying the wavelength of the light and then emitting the light by fluorescence, typically in a visible wavelength. In this instance the benefit is the UV light absorption by the fluorescent material preventing it from penetrating the film and/or transforming the UV into wavelengths that do not cure the photopolymer.

Table I below summarizes the results of experiments adding either brighteners or absorbers to solvent-based inkjet ink and measuring the transmission of UV light from two different UV light sources used to make flexo plates.

**TABLE I**

| **UV MASK for Solvent BLUE DYE - 0.5% (5000ppm) Addition (01-24-2013)** | | | | | | | |
|---|---|---|---|---|---|---|---|
| | **Light Source:** | **UVITRON*** | | | **IDEAL**** | | |
| | | **UV-Transparency** | | | **UV-Transparency** | | |
| | **Sample** | Light Intensity: mW/cm² | % Transmission | % Decrease | Light Intensity: mW/cm² | % Transmission | % Decrease |
| 1. | Empty | 2.53 | | | 1.281 | | |
| 2. | 2-Glass Slides | 2.17 | 100 | 0 | 0.988 | 100 | 0 |
| 3. | Blue Dye - Control | 1.011 | 46.6 | baseline | 0.326 | 33.0 | baseline |
| 4. | *Tnuvin P - 5000ppm* | 0.913 | 42.1 | 4.5 | 0.298 | 30.2 | 2.8 |
| 5. | *Tinuvin 328 - 5000 ppm* | 0.467 | 21.5 | 25.1 | 0.135 | 13.7 | 19.3 |
| 6. | *Tinuvin 5151-5000 ppm* | 0.505 | 23.3 | 23.3 | 0.233 | 23.6 | 9.4 |
| 7. | UV-Bright. 4061 - 5000 ppm | 0.47 | 21.7 | 24.9 | 0.0648 | 6.6 | 26.4 |
| 8. | UV-Bright. 4059-5000 ppm | 0.397 | 18.3 | 28.3 | 0.091 | 9.2 | 23.8 |
| 9. | **Prophetic Result** | **0.360** | **16.6** | **30.0** | **0.030** | **3.0** | **30.0** |

| | | | | | | | |
|---|---|---|---|---|---|---|---|
| * Intelli-Ray 400 Exposure Unit ** 1200 Stamp Exposure Unit | | | | | | | |

Two different light sources were used in these experiments, the Uvitron emitting almost double the light intensity of the Ideal unit. (See row 1). Provided a sufficient amount of light is blocked by the dark areas of the negative, the unfiltered intensity of the source only affects the exposure time. The choice of source is therefore determined principally by its cost of operation and useful life.

The solvent-based ink used in these experiments was a UV mask blue dye at 5000 ppm. The ink was applied between two glass slides, which supported the ink layer. Row 2 gives the light absorption results of the two glass slides without ink to simulate clear film and the associated small amount of UV absorption. As shown in row 3, this ink layer blocked only about one-half to two-thirds of the UV light passing through the glass in the applicable curing wavelength range of 240 to 360 nanometers. This is represented by the % transmission figures of 46.6% and 33.0% for the two light sources, respectively. Equivalent light filtration results can be obtained not only by printing an even UV mask dye or pigment coating on the film but also by adding dye or pigment to the film itself during manufacture, or by covering the film on either side with a dyed or pigmented light filter sheet. In the claims, these effects will be referred to in common as "filtering laminate," even if the "laminate" is merely a dyed polyester sheet printed with solvent-based ink.

Rows 4 - 6 show the results of adding Tinuvin^{®} light stabilizers (UV absorbers) to the inkjet negative imaging ink. Rows 7 - 9 show the results of adding UV-Bright brighteners (UV absorbing and fluorescent reflecting compounds to the inkjet negative imaging ink.

The amounts of UV brighteners and absorbers added to the ink in these experiments did not have any visible effect on the physical attributes of solvent ink, and because the amounts added were less than 1%, it is reasonable to expect that the inks prepared to generate the experimental and prophetic results listed below will run satisfactorily on an inkjet printer.

The brighteners (rows 7 - 9) seemed to have the greatest impact on UV blocking. Based on successful opacity levels used in the production processes, a goal was set for these experiments to produce an ink with about 30 percentage points greater blockage of light than that of the row 3 - "baseline" ink alone. While this % decrease was not achieved in the experiments, the 28.3% decrease using the UV-Bright 4059 brightener is very close. A prophetic result is generated and shown on row 9 of Table I by assuming that a 30% decrease could be achieved and calculating from it the corresponding overall light intensities corresponding to it, namely, 0.360 and 0.030 mW/cm², respectively (all underlined and bold in the table). However, this table does not specify other particular combinations of filtering, absorbers, and brighteners could achieve successful results. A combination of both UV absorbers and brighteners will block a wider spectrum of UV Light.

Table II does this with the data from the Uvitron exposure unit by calculating the light intensities that are estimated from linear combinations of additional filtering, absorbers, and brighteners.

**TABLE II**

| UVITRON | | | | | |
|---|---|---|---|---|---|
| | Sample | Light Intensity mW/cm² | Fraction of UV Penetration | Product of UV Penetration | Total Light Intensity Penetration mW/cm² |
| 1. | Empty | 2.530 | | | |
| 2. | 2-Glass Slides | 2.170 | | | |
| 3. | Blue Dye - Control "filtering laminate" | 1.011 | 0.466 | 0.466 | **1.011** |
| 4. | Tinuvin P - 5000 ppm | 0.913 | | | |
| 5. | Tinuvin 328 - 5000 ppm | 0.467 | 0.215 | 0.100 | **0.218** |
| 6. | Tinuvin 5151 - 5000 ppm | 0.505 | | | |
| 7. | UV-Bright. 4061 - 5000 ppm | 0.470 | | | |
| 8 | UV-Bright. 4059 - 5000 ppm | 0.397 | 0.183 | 0.085 | **0.185** |
| 9 | Prophetic | **0.360** | NA | NA | NA |

Here, as in Table I, the measured UV light intensities are shown in the second column, rows 1-8. Note that, as also shown in Table I, the 30% light decrease goal corresponds to a prophetic final intensity of 0.360 mW/cm².

The Total Light Intensity Penetration for combinations of the dye control "filtering laminate" and either the UV absorbers (rows 4-6) or the brighteners (rows 7-8) shown in the rightmost column was calculated as follows. First, the Fraction of UV Penetration for rows 3, 5 and 8 was calculated by dividing the Light Intensity value in the second column of rows 3, 5 and 8 by the control Light Intensity of row 3, second column. The combined fractional UV penetration of the combination of the Control "filtering laminate" and the absorber in row 5 is given by the product of the Fraction of UV Penetration in row 5 (0.215) and row 3 (0.466). The result appears in the Product of UV Penetration column in row 5 (0.100). The Total Light Intensity Penetration through both the filtering laminate and the absorber in the ink is therefore that fraction (0.100) times the control intensity (second column, row 3) namely, 0.218 milliwatt per square centimeter. The Total Light Intensity Penetration is not shown for rows 4 and 6 because they were higher than 0.218. The same algorithm was followed to calculate the lowest Total Light Intensity Penetration through the combination of filtering laminate and brightener, which turned out to be 0.185 mW/cm². While the total light intensity penetration of the blue dye control filtering laminate by itself is too high to reach the goal by a large margin, the product of its light reduction and that of Tinuvin^{®} 328 (row 5) produces the combined light intensity of 0.218 mW/cm², below that necessary to meet the goal. The same is true of the combination of the blue dye control and UV-Bright 4059 (0.185 mW/cm²). These compare favorably to the combined prophetic measured light intensity of 0.360.

Turning now to Table III, the prophetic results of working with the Ideal light source are calculated.

**TABLE III**

| IDEAL | | | | | |
|---|---|---|---|---|---|
| | Sample | Light Intensity mW/cm² | Fraction of UV Penetration | Product of UV Penetration | Total Light Intensity Penetration mW/cm² |
| 1. | Empty | 1.281 | | | |
| 2. | 2-Glass Slides | 0.988 | | | |
| 3. | Blue Dye - Control "filtering laminate" | **0.220** | 0.223 | 0.223 | 0.220 |
| 4. | Tinuvin P - 5000 ppm | 0.298 | | | |
| 5. | Tinuvin 328 - 5000 ppm | 0.135 | 0.137 | 0.030 | **0.030** |
| 6. | Tinuvin 5151 - 5000 ppm | 0.233 | | | |
| 7. | UV-Bright. 4061 - 5000 ppm | 0.065 | 0.066 | 0.015 | **0.014** |
| 8. | UV-Bright. 4059-5000 ppm | 0.091 | | | |
| 9. | Prophetic | **0.030** | 0.030 | 0.007 | 0.007 |

Note that in this case, if the concentration of dye in the blue dye control "filtering laminate" were increased to cause its light output to drop from 0.326 mW/cm² to 0.220 mW/cm², combining that with Tinuvin^{®} 328 would equal the prophetic result of 0.030. Adding UV-Bright 4061 to the ink as well would produce a light intensity underneath the negative images of 0.014 mW/cm². It is reasonable to predict that if the concentration of dye in the control were changed from 5000 ppm to a higher level (perhaps in proportion to the additional amount of light needed to be absorbed) the output UV light intensity could be reduced to 0.220 mW/cm² and produce the prophetic result.

The present invention and the experiments were directed at producing solvent-based inkjet negatives, or laminates containing such negatives, for the purpose of controlling UV exposure in flexo plate manufacture. The claimed matter also applies to other apparatuses and processes in which it would be advantageous to control light penetration, or exposure of other photoreactive materials, using combinations of filters and solvent ink compatible films.

## Claims

1. A solvent-based inkjet negative, **characterised in that** a polymeric film compatible with solvent-based ink and having inked areas is provided, the polymeric film being thin in one dimension, broad in the two other dimensions, a surface in the two other dimensions to be illuminated by a light having an initial intensity, a first combination of light filtering substances uniformly spread in the other two dimensions, the ink comprising a second combination of light filtering substances_and being printed on the surface, the first and second combinations of light filtering substances preventing polymerization of photopolymers opposite to the surface to be illuminated when light is shone on the surface to be illuminated, the first combination of light filtering substances is taken from the list of: a. none; b. at least one layer of fluorescent substance; c. at least one layer of light-reflecting substance; d. at least one layer of light absorbing substance; e. at least one fluorescent substance dispersed within the film; f. at least one light-reflecting substance dispersed within the film; g. at least one light absorbing substance dispersed within the film; and h. any combination of b. through g. above; and said second combination of light filtering substances is taken from the list of: i. a fluorescent substance; j. a light-reflecting substance; k. a light absorbing substance; and l. any combination of i. through k. above.

2. A negative as claimed in claim 1, **characterised in that** said first combination of light filtering substances reduces the initial intensity by at least 50% and said second combination of light filtering substances reduces the initial intensity by at least an additional 30 percentage points.

3. A light filtering laminate, **characterised in that** at least one layer is provided comprising a first substance taken from the list of a. none; b. at least one substance which absorbs light of a specified wavelength range and fluoresces in a wavelength other than the specified wavelength range; c. at least one substance that reflects light of a specified wavelength range away from a layer of photoreactive material; d. at least one substance that absorbs light of a specified wavelength range and converts it to heat; and e. any combination of a. through d. above; and at least one layer printed with a negative image comprising a solvent-based ink, the ink comprising a second substance taken from the list of: f. at least one substance which absorbs light of a specified wavelength range and fluoresces in a wavelength other than the specified wavelength range; g. at least one substance that reflects light of a specified wavelength range away from the photoreactive material; h. at least one substance that absorbs light of a specified wavelength range and converts it to heat; and i. any combination off. through h. above, the unprinted areas in the light filtering laminate reducing the intensity of light of a specified wavelength range passing through the light filtering laminate by at least 50% and the ink reducing the intensity of the light of a specified wavelength range passing through the printed areas by at least an additional 30 percentage points.

4. A light filtering laminate as claimed in claim 3, **characterised in that** said at least one layer comprises a first substance and said at least one layer printed with a negative image are one and the same.

5. A light filtering laminate as claimed in claim 3 or claim 4, **characterised in that** said specified wavelength range is about 200 to 400 nanometers.

6. A light filtering laminate as claimed in claim 5, **characterised in that** said specified wavelength range is about 240 to 360 nanometers.

7. A method for making a light filtering laminate, **characterised in** the steps of a. adding at least zero light filtering substances to at least one layer of light transmitting material; b. adding at least one light filtering substance to a solvent-based inkjet printing ink; c. using the ink from step b. to print a negative image on at least one layer of film compatible with solvent-based inkjet ink; and d. superimposing any resulting plurality of layers, the light filtering substances being taken from the list of: e. at least one substance which absorbs light of a specified wavelength range and fluoresces in a wavelength other than a specified wavelength range; f. at least one substance that reflects light of a specified wavelength range away from the photo reactive material and g. at least one substance that absorbs light of a specified wavelength range and converts it to heat, the unprinted areas in the light filtering laminate reducing the intensity of light of a specified wavelength range passing through the light filtering laminate by at least 50%; and the ink further reducing the intensity of light of a specified wavelength range passing through the light filtering laminate by at least an additional 30 percentage points.

8. A method as claimed in claim 7, **characterised in that** said specified wavelength range is about 200 to 400 nanometers.

9. A method as claimed in claim 8, **characterised in that** said specified wavelength range is about 240 to 360 nanometers.

## Patentansprüche

1. Lösungsmittelbasiertes Tintenstrahl-Negativ, **dadurch gekennzeichnet, dass** ein Polymerfilm, der mit lösungsmittelbasierter Tinte kompatibel ist und Bereiche mit Tinte aufweist, bereitgestellt wird, wobei der Polymerfilm in einer Dimension dünn ist und in den anderen zwei Dimensionen ausgedehnt ist, wobei eine Oberfläche in den zwei anderen Dimensionen durch ein Licht mit einer Anfangsintensität zu beleuchten ist, wobei eine erste Kombination von lichtfilternden Substanzen gleichförmig in den anderen zwei Dimensionen verteilt ist, wobei die Tinte eine zweite Kombination von lichtfilternden Substanzen aufweist und auf die Oberfläche aufgedruckt ist, wobei die erste und zweite Kombination von lichtfilternden Substanzen eine Polymerisierung von der zu beleuchtenden Oberfläche gegenüberliegenden Fotopolymeren verhindert, wenn Licht auf die zu beleuchtende Oberfläche einstrahlt, wobei die erste Kombination von lichtfilternden Substanzen aus der Liste ausgewählt ist bestehend aus; a. keine; b. wenigstens eine Schicht fluoreszierender Substanz; c. wenigstens eine Schicht lichtreflektierender Substanz; d. wenigstens eine Schicht lichtabsorbierender Substanz; e. wenigstens eine innerhalb des Films dispergierte fluoreszierende Substanz; f. wenigstens eine innerhalb des Films dispergierte lichtreflektierende Substanz; g. wenigstens eine innerhalb des Films dispergierte lichtabsorbierende Substanz; und h. jede Kombination der obigen b. bis g ; und wobei die zweite Kombination fichtfilternder Substanzen aus der Liste ausgewählt ist bestehend aus: i. einer fluoreszierenden Substanz; j. einer lichtreflektierenden Substanz; k. einer lichtabsorbierenden Substanz; und l. jede Kombination der obigen i. bis k.

2. Negativ nach Anspruch 1, **dadurch gekennzeichnet, dass** die erste Kombination lichtfilternder Substanzen die Anfangsintensität um wenigstens 50% reduziert und die zweite Kombination lichtfilternder Substanzen die Anfangsintensität um wenigstens zusätzliche 30 Prozentpunkte reduziert.

3. Lichtfilterndes Laminat, **dadurch gekennzeichnet, dass** wenigstens eine Schicht bereitgestellt wird, die eine erste Substanz aufweist, die aus der Liste ausgewählt ist bestehend aus a. keiner; b. wenigstens eine Substanz, die Licht eines bestimmten Wellenlängenbereiches absorbiert und in einer von dem bestimmten Wellenlängenbereich verschiedenen Wellenlänge fluoresziert; c. wenigstens eine Substanz, die Licht eines bestimmten Wellenlängenbereichs von einer Schicht fotoreaktiven Materials weg reflektiert; d. wenigstens eine Substanz, die Licht eines bestimmten Wellenlängenbereichs absorbiert und in Wärme umwandelt; und e. jede Kombination der obigen a. bis d.; und wenigstens eine Schicht, die mit einem Negativabbild bedruckt ist, das eine lösungsmittelbasierte Tinte aufweist, wobei die Tinte eine zweite Substanz aufweist, die aus der folgenden Liste ausgewählt ist: f. wenigstens eine Substanz, die Licht eines bestimmten Wellenlängenbereichs absorbiert und in einem von dem bestimmten Wellenlängenbereich verschiedenen Wellenlänge fluoresziert; g. wenigstens eine Substanz, die Licht eines bestimmten Wellenlängenbereichs von dem fotoreaktiven Material weg reflektiert; h. wenigstens eine Substanz, die Licht eines bestimmten Wellenlängenbereichs absorbiert und in Wärme umwandelt; und i. jede Kombination der obigen f. bis h., wobei die nichtbedruckten Bereiche in dem lichtfilternden Laminat die Lichtintensität eines bestimmten Wellenlängenbereichs, die durch das lichtfilternde Laminat dringt, um wenigstens 50% reduzieren und die Tinte die Intensität des Lichts eines bestimmten Wellenlängenbereichs, das durch die bedruckten Bereiche dringt, um wenigstens zusätzliche 30 Prozentpunkte reduziert.

4. Lichtfilterndes Laminat nach Anspruch 3, **dadurch gekennzeichnet, dass** die wenigstens eine Schicht eine erste Substanz aufweist und die wenigstens eine Schicht, die mit einem Negativabbild bedruckt ist, ein und dieselbe sind.

5. Lichtfilterndes Laminat nach Anspruch 3 oder Anspruch 4, **dadurch gekennzeichnet, dass** der bestimmte Wellenlängenbereich etwa 200 bis 400 Nanometer ist.

6. Lichtfilterndes Laminat nach Anspruch 5, **dadurch gekennzeichnet, dass** der bestimmte Wellenlängenbereich etwa 240 bis 360 Nanometer ist.

7. Verfahren zum Herstellen eines lichtfilternden Laminats, **gekennzeichnet durch** die folgenden Schritte: a. Hinzufügen von wenigstens null lichtfilternden Substanzen zu wenigstens einer Schicht von lichttransmittierendem Material; b. Hinzufügen von wenigstens einer lichtfilternden Substanz zu einer lösungsmittelbasierten Tintenstrahldrucktinte; c. Verwenden der Tinte aus Schritt b. zum Drucken eines Negativabbildes auf wenigstens einer Filmschicht, die mit lösungsmittelbasierter Tintenstrahltinte kompatibel ist; und d. Überlagern jeder sich ergebenen Vielzahl von Schichten, wobei die lichtfilternden Substanzen aus der folgenden Liste ausgewählt sind: e, wenigstens eine Substanz, die Licht eines bestimmten Wellenlängenbereichs absorbiert und in einer von einem bestimmten Wellenlängenbereich verschiedenen Weltenlänge fluoresziert; f. wenigstens eine Substanz, die Licht eines bestimmten Wellenlängenbereiches von dem fotoreaktiven Material weg reflektiert; und g. wenigstens eine Substanz, die Licht eines bestimmten Wellenlängenbereichs absorbiert und in Wärme umwandelt, wobei die nichtbedruckten Bereiche in dem lichtfilternden Laminat die Lichtintensität eines bestimmten Wellenlängenbereichs, der **durch** das lichtfilternde Laminat dringt, um wenigstens 50% reduzieren; und wobei die Tinte weiter die Lichtintensität eines bestimmten Wellenlängenbereiches, der **durch** das lichtfilternde Laminat dringt, um wenigstens zusätzlich 30 Prozentpunkte reduziert.

8. Verfahren nach Anspruch 7, **dadurch gekennzeichnet, dass** der bestimmte Wellenlängenbereich etwa 200 bis 400 Nanometer ist.

9. Verfahren nach Anspruch 8, **dadurch gekennzeichnet, dass** der bestimmte Wellenlängenbereich etwa 240 bis 360 Nanometer ist.

## Revendications

1. Négatif pour jet d'encre à base de solvant, **caractérisé en ce qu'**il est prévu un film polymère compatible avec une encre à base de solvant et comportant des zones encrées, le film polymère étant mince dans une première dimension et large dans les deux autres dimensions, une surface dans les deux autres dimensions destinée à être éclairée par une lumière ayant une intensité initiale, une première combinaison de substances filtrant la lumière étalée de façon uniforme dans les deux autres dimensions, l'encre comprenant une deuxième combinaison de substances filtrant la lumière et étant imprimée sur la surface, les première et deuxième combinaisons de substances filtrant la lumière empêchant la polymérisation des photopolymères opposés à la surface destinée à être éclairée lorsqu'une lumière est projetée sur la surface destinée à être éclairée, la première combinaison de substances filtrant la lumière est issue de la liste suivante : a. aucune ; b. au moins une couche d'une substance fluorescente ; c. au moins une couche d'une substance réfléchissant la lumière ; d. au moins une couche d'une substance absorbant la lumière ; e. au moins une substance fluorescente dispersée dans le film ; f. au moins une substance réfléchissant la lumière dispersée dans le film; g. au moins une substance absorbant la lumière dispersée dans le film ; et h. une combinaison quelconque des éléments b. à h. précités ; et ladite deuxième combinaison de substances filtrant la lumière est issue de la liste suivante : i. une substance fluorescente ; j. une substance réfléchissant la lumière ; k. une substance absorbant la lumière ; et l. une combinaison quelconque des éléments i. à k. précités.

2. Négatif selon la revendication 1, **caractérisé en ce que** ladite première combinaison de substances filtrant la lumière réduit l'intensité initiale d'au moins 50 % et ladite deuxième combinaison de substances filtrant la lumière réduit l'intensité initiale d'au moins 30 points de pourcentage supplémentaires.

3. Stratifié filtrant la lumière, **caractérisé en ce qu'**il est prévu au moins une couche comprenant une première substance issue de la liste suivante : a. aucune ; b. au moins une substance qui absorbe la lumière d'une plage de longueur d'onde spécifique et montre une fluorescence dans une longueur d'onde autre que la plage de longueur d'onde spécifique ; c. au moins une substance qui réfléchit la lumière d'une plage de longueur d'onde spécifique loin d'une couche d'un matériau photoréactif ; d. au moins une substance qui absorbe la lumière d'une plage de longueur d'onde spécifique et la convertit en chaleur ; et e. une combinaison quelconque des éléments a. à d. précités ; et au moins une couche imprimée avec une image négative comprenant une encre à base de solvant, l'encre comprenant une deuxième substance issue de la liste suivante : f. au moins une substance qui absorbe la lumière d'une plage de longueur d'onde spécifique et montre une fluorescence dans une longueur d'onde autre que la plage de longueur d'onde spécifique ; g. au moins une substance qui réfléchit la lumière d'une plage de longueur d'onde spécifique loin du matériau photoréactif ; h. au moins une substance qui absorbe la lumière d'une plage de longueur d'onde spécifique et la convertit en chaleur ; et i. une combinaison quelconque des éléments f. à h. précités, les zones non imprimées du stratifié filtrant la lumière réduisant l'intensité d'une lumière d'une plage de longueur d'onde spécifique passant à travers le stratifié filtrant la lumière d'au moins 50 % et l'encre réduisant l'intensité de la lumière d'une plage de longueur d'onde spécifique passant à travers les zones imprimées d'au moins 30 points de pourcentage supplémentaires.

4. Stratifié filtrant la lumière selon la revendication 3, **caractérisé en ce que** ladite au moins une couche comprenant une première substance et ladite au moins une couche imprimée avec une image négative sont une seule et même couche.

5. Stratifié filtrant la lumière selon la revendication 3 ou la revendication 4, **caractérisé en ce que** ladite plage de longueur d'onde spécifique va d'environ 200 à 400 nanomètres.

6. Stratifié filtrant la lumière selon la revendication 5, **caractérisé en ce que** ladite plage de longueur d'onde spécifique va d'environ 240 à 360 nanomètres.

7. Procédé de fabrication d'un stratifié filtrant la lumière, **caractérisé en ce qu'**il comporte les étapes suivantes : a. ajout d'au moins aucune substance filtrant la lumière à au moins une couche d'un matériau transmettant la lumière, b. ajout d'au moins une substance filtrant la lumière à une encre d'impression à jet d'encre à base de solvant; c. utilisation de l'encre de l'étape b. pour imprimer une image négative sur au moins une couche de film compatible avec une encre pour jet d'encre à base de solvant ; et d. superposition d'une quelconque pluralité de couches obtenues, les substances filtrant la lumière étant issues de la liste suivante : e. au moins une substance qui absorbe la lumière d'une plage de longueur d'onde spécifique et montre une fluorescence dans une longueur d'onde autre que la plage de longueur d'onde spécifique ; f. au moins une substance qui réfléchit la lumière d'une plage de longueur d'onde spécifique loin du matériau photoréactif et g. au moins une substance qui absorbe la lumière d'une plage de longueur d'onde spécifique et la convertit en chaleur, les zones non imprimées du stratifié filtrant la lumière réduisant l'intensité d'une lumière d'une plage de longueur d'onde spécifique passant à travers le stratifié filtrant la lumière d'au moins 50 % ; et l'encre réduisant en outre l'intensité de la lumière d'une plage de longueur d'onde spécifique passant à travers le stratifié filtrant la lumière d'au moins 30 points de pourcentage supplémentaires.

8. Procédé selon la revendication 7, **caractérisé en ce que** ladite plage de longueur d'onde spécifique va d'environ 200 à 400 nanomètres.

9. Procédé selon la revendication 8, **caractérisé en ce que** ladite plage de longueur d'onde spécifique va d'environ 240 à 360 nanomètres.
